# EUROPEAN PATENT SPECIFICATION

(11) **EP 2 409 487 B1**
(45) Date of publication and mention of the grant of the patent: **27.01.2016**
(21) Application number: 10753341.6
(22) Date of filing: 01.02.2010
(51) Int. Cl.: H04N 5/335, H01L 27/146, H04N 5/232, H04N 9/07, H04N 5/369, H04N 5/353, H04N 5/374

(54) **IMAGE CAPTURING APPARATUS AND METHOD OF CONTROLLING AN IMAGE CAPTURING APPARATUS**
BILDAUFNAHMEVORRICHTUNG UND VERFAHREN ZUR STEUERUNG EINER BILDAUFNAHMEVORRICHTUNG
APPAREIL DE CAPTURE D'IMAGE ET PROCÉDÉ DE COMMANDE D'UN APPAREIL DE CAPTURE D'IMAGE

(30) Priority: 17.03.2009 JP 2009065221
(43) Date of publication of application: 25.01.2012
(73) Proprietor: Canon Kabushiki Kaisha, Tokyo 146-8501 (JP)
(72) Inventor: TANIGUCHI, Hidenori, Tokyo 146-8501 (JP)
(74) Representative: TBK
(86) International application number: PCT/JP2010/051727
(87) International publication number: WO 2010/106846

(56) References cited:
- EP-A2- 0 981 245
- EP-A2- 1 986 045
- JP-A- 2008 085 535
- JP-A- 2009 049 858
- JP-A- 2009 089 105

## Description

### TECHNICAL FIELD

The present invention relates to an image capturing apparatus that includes an image sensor having multiple pixels arranged in two-dimensional form.

### BACKGROUND ART

The contrast detection technique (also called the "blur technique") and the phase difference detection technique (also called the "skew technique") are known as general techniques for auto focus detection/adjustment methods in image capturing apparatuses using light beams that have passed through an imaging lens. The contrast detection technique is a technique widely used in video movie devices that capture moving images (camcorders), digital still cameras, and so on, and in such a case, the image sensor thereof is used as a focus detection sensor. This technique focuses on the signal outputted from the image sensor, and particularly information of the high-frequency components (contrast information) thereof, and uses the position of the imaging lens where the evaluation value of that high-frequency component information is the highest as the in-focus position. However, as implied by the name "hill-climbing technique", the evaluation value is found while minutely moving the imaging lens, and it is ultimately necessary to move the lens to where the maximum evaluation value can be detected; this technique is therefore unsuited to quick focus adjustments.

The other technique, which is the phase difference detection technique, is often employed in single-lens reflex cameras that use silver film, and is the technique that has contributed the most to the practical application of auto focus (AF) detection in single-lens reflex cameras. With the phase difference detection technique, a light beam passing through the exit pupil of the imaging lens is divided into two parts, and the resulting light beams are received by a pair of focus detection sensors; the amount of skew in signals outputted based on the amount of light received, or in other words, the amount of relative positional skew in the division direction of the light beam, is detected. As a result, the amount of skew in the focus direction of the imaging lens is detected directly. Accordingly, the amount and direction of the focus skew can be obtained by performing a single accumulation operation using the focus detection sensor, thus making fast focus adjustment operations possible. However, in order to divide the light beam that has passed through the exit pupil of the imaging lens into two parts and obtain signals corresponding to the resulting light beams, a means for dividing the optical path, such as a quick return mirror, a half mirror, or the like, is generally provided in the optical path for imaging, and a focus detection optical system and AF sensor are generally provided at the end thereof. This is disadvantageous in that it increases the size and cost of the apparatus.

In order to circumvent the aforementioned disadvantage, a technique has been proposed in which an image sensor is provided with phase difference detection functionality in order to eliminate the necessity for a dedicated AF sensor and realize highspeed phase difference AF.

For example, in Japanese Patent Laid-Open No. 2000-156823 (hereinafter, "Patent Document 1"), a pupil division function is provided by offsetting the sensitive region of the light-receiving portion relative to the optical axis of an on-chip microlens in some light-receiving elements (pixels) in an image sensor. A configuration that performs phase difference focus detection is realized by using those pixels as focus detection pixels and disposing the focus detection pixels at predetermined intervals in groups of pixels used for imaging. Because the areas in which the focus detection pixels are arranged correspond to areas in which imaging pixels are absent, image information is produced through interpolation using the information from peripheral imaging pixels. In addition, when shooting moving images, thinning is executed while reading out from the image sensor, but in the case where a certain frame rate is demanded, as with moving images, the production of image information by compensating for losses caused by the focus detection pixels is too slow, and therefore the focus detection pixels are arranged in a row that is not read out during this thinning readout.

Meanwhile, Japanese Patent Laid-Open No. 2003-189183 (hereinafter, "Patent Document 2") discloses an image capturing apparatus capable of switching between a thinning readout mode and an adding readout mode for output with the goal of improving the image quality of moving images and improving the sensitivity at low luminosities. In other words, Patent Document 2 proposes improving the image quality of moving images by performing readout in the adding mode in order to reduce moirés when the object has a high spatial frequency and the occurrence of moirés can be foreseen, or using the thinning readout mode in the case where the luminosity is high and the occurrence of smearing can be foreseen.

In addition, in Japanese Patent Laid-Open No. 2008-85535 (hereinafter, "Patent Document 3"), a pupil division function is provided by offsetting the sensitive region of the light-receiving portion relative to the optical axis of an on-chip microlens in some light-receiving elements (pixels) in an image sensor, in the same manner as in Patent Document 1. A configuration that performs phase difference focus detection is realized by using those pixels as focus detection pixels and arranging the focus detection pixels at predetermined intervals in groups of pixels used for imaging. Patent Document 3 also proposes taking accumulation control signals from the image sensing pixel groups and the focus detection pixel groups independently and employing different accumulation times for the two pixel groups, thereby improving the frame rate of the captured image and improving the performance of the focus detection pixel group with respect to low-luminosity objects.

However, the aforementioned known techniques have problems such as those described hereinafter.

With the technique disclosed in Patent Document 1, there are three types of readout modes: a still image mode that reads out all the pixels; a thinning readout mode that performs thinning so as to read out only the rows in which imaging pixel groups are present; and a ranging readout mode that reads out only the focus detection pixel groups. For this reason, the focus detection pixels are not read out when using the electronic viewfinder, when in a moving image mode, and so on, and thus while the frame rate of moving images can be improved, there is a problem in highspeed focus detection using the phase difference technique is impossible while a moving picture is being displayed.

The invention disclosed in Patent Document 2 relates to switching between a thinning readout mode and an adding readout mode depending on the scene when performing readouts for moving images. Focus detection pixels are not arranged in the image sensor, and thus using some of the pixels in the image sensor to perform phase difference focus detection is not considered from the outset. Even if, for example, focus detection pixels were present, those focus detection pixels could not be used for image information due to the reasons described earlier, and thus during the adding readout mode, the focus detection pixels would not be able to be added to the image capturing pixels. Furthermore, if an attempt was made to perform focus detection using the focus detection pixels, it would be necessary to read out the focus detection pixels singly even during the adding readout mode.

The invention disclosed in Patent Document 3 employs a configuration in which accumulation control signals from image sensing pixel groups and focus detection pixel groups are taken independently and the optimal accumulation times for the respective pixel groups can be set, thereby balancing image display refresh capabilities with rangefinding capabilities for low-luminosity objects. However, this is problematic in that the number of signal wires arranged between pixels increases, leading to a drop in the numerical aperture of the pixels and a drop in the sensitivity thereof. Meanwhile, Patent Document 3 discloses, as a variation on the invention described therein, commonalizing the accumulation control signals between the image sensing pixels and the focus detection pixels. This is advantageous in that the wiring between the image sensing pixels and the focus detection pixels is reduced, thereby improving the numerical aperture. However, this also means that the accumulation control is the same for both the image sensing pixels and the focus detection pixels. Therefore, Patent Document 3 discloses adding the output of the focus detection pixel groups multiple times in order to improve the S/N ratio of the focus detection pixels. However, this is problematic because even if that output is added following the readout, noise from a pixel amplifier, a readout gain amplifier, or the like is added multiple times as well, and thus the S/N ratio is not improved as in the case of accumulation time control.

Document EP 1 986 045 A2 discloses a focus detection device comprising an image shift detection means for detecting a relative shift amount of a pair of images formed by a pair of light fluxes having passed through an optical system and conversion means for converting the shift amount to the defocus amount based upon dimensional information of exit pupil corresponding to an aperture restricting light flux in the optical system and distance information of the exit pupil indicating distances to the exit pupil from a predetermined imaging plane of the optical system.

### DISCLOSURE OF INVENTION

Having been achieved in light of the aforementioned problems, the present invention improves the S/N ratio of focus detection pixels when performing focus detection using the phase difference technique during the display of a moving picture.

In order to solve the aforementioned problems and achieve the aforementioned improvement, according to an aspect of the present invention, there is provided an image capturing apparatus as defined in claim 1. Further, there is provided a method as defined in claim 9. Further aspects and features of the present invention are set out in the dependent claims.

Further features of the present invention will become apparent from the following description of exemplary embodiments (with reference to the attached drawings).

### BRIEF DESCRIPTION OF DRAWINGS

FIG. 1 is a diagram illustrating the configuration of a camera according to a first embodiment of the present invention.
FIGS. 2A and 2B are a plan view and a cross-sectional view, respectively, of an image sensing pixel in an image sensor according to the first embodiment.
FIGS. 3A and 3B are a plan view and a cross-sectional view, respectively, of a focus detection pixel in the image sensor according to the first embodiment.
FIG. 4 is a diagram illustrating a pixel array in the image sensor according to the first embodiment.
FIG. 5 is a diagram illustrating a pixel circuit in the image sensor according to the first embodiment.
FIG. 6 is a block diagram illustrating the overall configuration of the image sensor according to the first embodiment.
FIG. 7 is a diagram illustrating accumulation and readout operations for the entirety of a screen according to the first embodiment.
FIG. 8 is a diagram illustrating accumulation and readout operations during thinning according to the first embodiment.
FIG. 9 is a diagram illustrating accumulation and readout operations during focus detection according to the first embodiment.
FIG. 10 is a diagram illustrating accumulation and readout operations during focus detection according to a second embodiment.
FIG. 11 is a diagram illustrating accumulation and readout operations during focus detection according to a third embodiment.

### BEST MODE FOR CARRYING OUT THE INVENTION

### (First Embodiment)

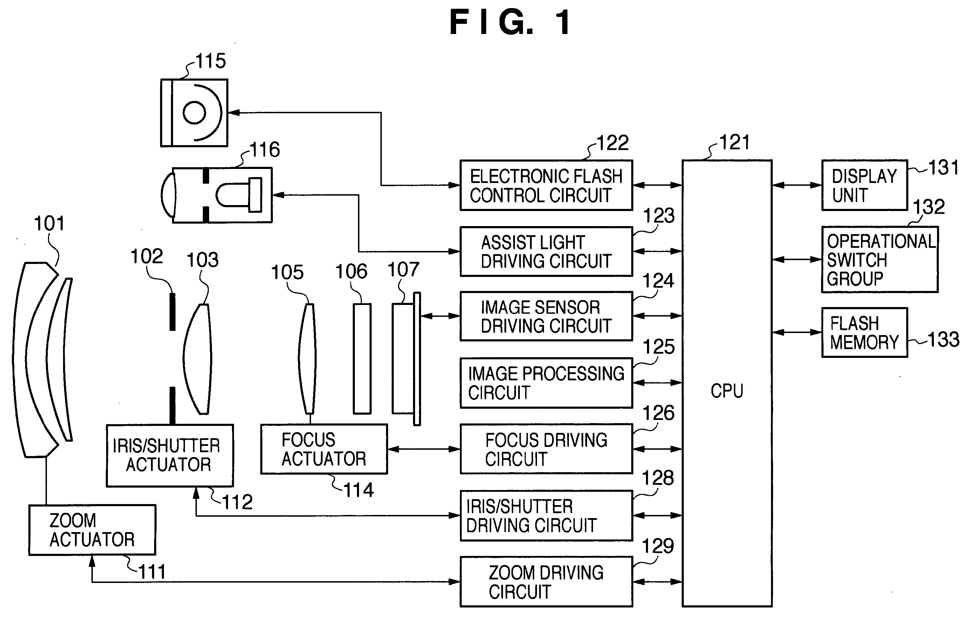

FIG. 1 is a diagram illustrating the configuration of a camera (image capturing apparatus) according to a first embodiment of the present invention, and illustrates a digital camera in which a camera body having an image sensor and an imaging lens are integrated in a single unit. In FIG. 1, 101 represents a first lens group arranged at the end of an imaging optical system (image formation optical system), the first lens group being held so as to be movable forward and backward in the optical axis direction. 102 represents an iris/shutter, and controlling the aperture diameter thereof enables the adjustment of the light amount during imaging; during still image capturing, the iris/shutter 102 also functions as an exposure time adjustment shutter. 103 represents a second lens group. The iris/shutter 102 and the second lens group 103 move backward and forward in the optical axis direction in unity, realizing a variable power effect (zoom function) by operating in tandem with the forward/backward operation of the first lens group 101.

105 represent a third lens group that performs focus adjustment by moving forward/backward in the optical axis direction. 106 represents an optical low-pass filter, which is an optical element for reducing false colors, moirés, and so on in captured images. 107 represents an image sensor configured of a CMOS sensor and a peripheral circuit thereof (a CMOS image sensor). A two-dimensional single-panel color sensor in which a Bayer-pattern primary color mosaic filter is formed on the chip above light-receiving pixels arranged two-dimensionally, with m pixels in the horizontal direction and n pixels in the vertical direction, is used for the image sensor 107. 111 represents a zoom actuator, which, by rotating a barrel cam (not shown), drives the first lens group 101 and the second lens group 103 forward/backward in the optical axis direction, thereby executing variable power operations. 112 represents an iris/shutter actuator, which controls the diameter of the aperture of the iris/shutter 102 so as to adjust the amount of imaging light, and controls the exposure time when capturing still images. 114 represents a focus actuator, which drives the third lens group 105 forward/backward in the optical axis direction, thereby adjusting the focus.

115 represents an electronic flash for illuminating objects during imaging, and although a flash illumination device employing a xenon tube is preferable, an illumination device provided with an LED that continuously emits light may be used as well. 116 represents an AF assist light, which projects, onto the object field via a projection lens, a mask image having a predetermined aperture pattern, thereby improving the focus detection capabilities with respect to dark objects or low-contrast objects. 121 represents a CPU, and is a CPU within the camera that performs various controls for the camera body. The CPU 121 includes a processing unit, a ROM, a RAM, an A/D converter, a D/A converter, a communication interface circuit, and the like; the CPU 121 drives various circuits within the camera based on predetermined programs stored within the ROM, and executes serial operations for performing AF, imaging, image processing, recording, and so on.

122 represents an electronic flash control circuit that controls the lighting of the electronic flash 115 in synchronization with imaging operations. 123 represents an assist light driving circuit that controls the lighting of the AF assist light 116 in synchronization with focus detection operations. 124 represents an image sensor driving circuit that controls the imaging operations of the image sensor 107, as well as performing A/D conversion on obtained image signals and transmitting those image signals to the CPU 121. 125 represents an image processing circuit that performs processing such as y conversion, color interpolation, JPEG compression, and so on on images obtained by the image sensor 107. 126 represents a focus driving circuit that controls the driving of the focus actuator 114 based on focus detection results, driving the third lens group 105 forward/backward in the optical axis direction so as to adjust the focus. 128 represents an iris/shutter driving circuit that controls the driving of the iris/shutter actuator 112 so as to control the aperture of the iris/shutter 102. 129 represents a zoom driving circuit that drives the zoom actuator 111 in response to zoom operations made by a user.

131 represents a display device, such as an LCD, that displays information regarding the imaging mode of the camera, pre-imaging preview images and post-imaging confirmation images, focus status display images during focus detection, and so on. 132 represents an operational switch group configured of a power switch, a shutter release (imaging trigger) switch, a zoom operation switch, an imaging mode selection switch, and so on. 133 represents a removable flash memory, in which captured images are stored.

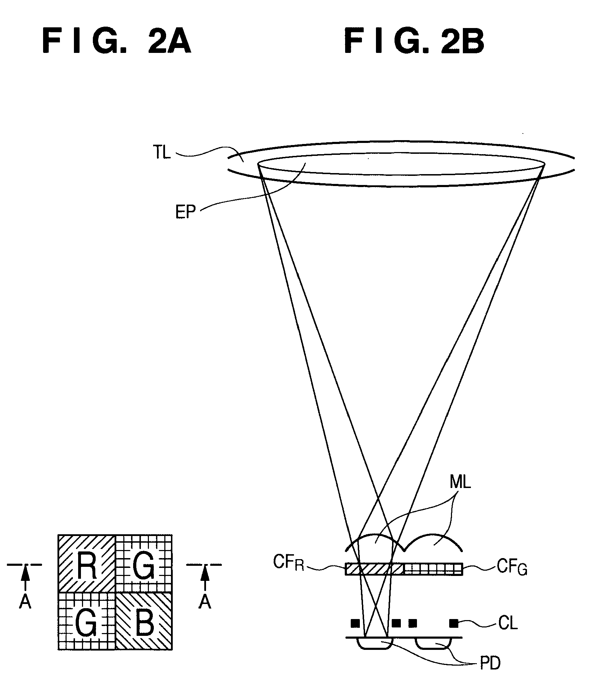

FIGS. 2A to 3B are diagrams illustrating the structure of image sensing pixels used for image generation and focus detection pixels used for phase difference detection employed in the image sensor of the present embodiment. The present embodiment employs a Bayer array, in which of four pixels in a 2 x 2 arrangement, two pixels having a G (green) spectral sensitivity are arranged opposite to each other on the diagonal, and one each of pixels having R (red) and B (blue) spectral sensitivities are arranged in the other two positions. Focus detection pixels having a structure that shall be described later are distributed between the Bayer arrays with a predetermined regularity.

FIGS. 2A and 2B illustrate the arrangement and structure of image sensing pixels. FIG. 2A is a plan view illustrating a 2 x 2 image sensing pixel. As is publicly known, in a Bayer array, G pixels are arranged opposite to each other on the diagonal, and R and B pixels are arranged in the other two pixel positions. This two-row by two-column structure is arranged repeatedly. FIG. 2B illustrates a cross-section viewed along the A-A line shown in FIG. 2A. ML indicates on-chip microlenses disposed on the uppermost surface of each pixel, whereas CFR indicates an R (red) color filter and CFG represents a G (green) color filter. PD schematically illustrates photoelectric conversion portions of the image sensor, whereas CL indicates a wiring layer for forming signal wires that transmit various types of signals within the CMOS sensor. TL schematically illustrates an imaging optical system.

Here, the on-chip microlenses ML and the photoelectric conversion portions PD of the image sensing pixel are configured to effectively capture, to the greatest extent possible, light beams that have passed through the imaging optical system ML. To rephrase, an exit pupil EP of the imaging optical system TL and the photoelectric conversion portions PD are designed to be in a conjugative relationship due to the microlenses ML, and so that the effective surface area of the photoelectric conversion portions is a large surface area. Furthermore, although FIG. 2B illustrates a light beam introduced into the R pixel, the same structure applies to both the G pixels and the B pixels. Therefore, the exit pupil EP has a large diameter in correspondence with the RGB pixels for imaging, thereby efficiently capturing light beams from an object and thus improving the S/N ratio of the image signal.

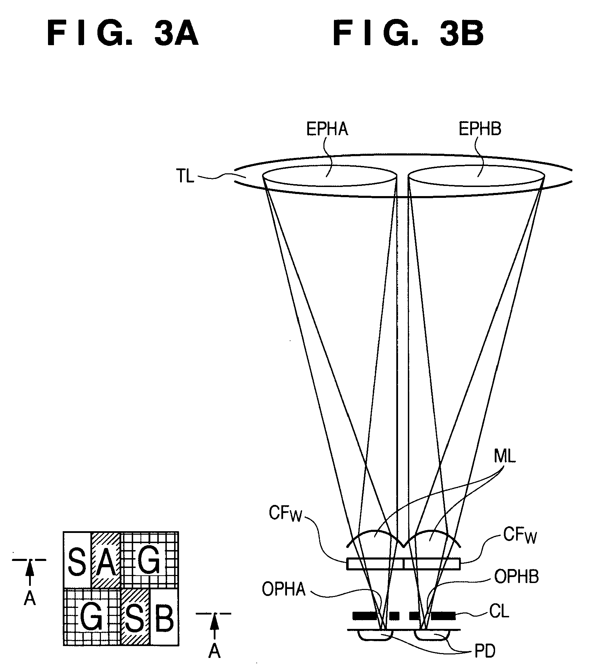

FIGS. 3A and 3B illustrate the arrangement and structure of focus detection pixels for dividing the pupil region on the imaging lens in the horizontal direction (sideways direction) into pupil regions. FIG. 3A is a plan view illustrating a two-row by two-column pixel that includes a focus detection pixel. When an imaging signal is obtained, the G pixels obtain the primary component of luminance information. Because the image recognition characteristics of humans are sensitive to luminance information, image quality degradation is apparent when there are losses in the G pixels. Meanwhile, although R and B pixels are pixels that obtain color information, humans are relatively insensitive to color information, and thus image quality degradation is not very apparent even if a certain degree of defects occur in pixels that obtain color information. Accordingly, in the present embodiment, of the pixels in the two-row by two-column arrangement, the G pixels are maintained as image sensing pixels, whereas the R pixels and B pixels are replaced with focus detection pixels. This is indicated by SA and SB in FIG. 3A.

FIG. 3B illustrates a cross-section viewed along the A-A line shown in FIG. 3A. The microlenses ML and the photoelectric conversion portions PD have the same structures as those of the image sensing pixels illustrated in FIG. 2B. In the present embodiment, the signals from the focus detection pixels are not used in the production of images, and thus a transparent film CFW (white) or CFG is disposed in place of the color separation color filters. In addition, because pupil division is carried out with the image sensor, the opening portions of the wiring layer CL are skewed in one direction relative to the centerline of the microlenses ML. To be more specific, a pixel SA and an opening portion OPHA thereof are skewed to the right, and thus receive a light beam that has passed through an exit pupil EPHA on the left side of the imaging lens TL. Similarly, a pixel SB and an opening portion OPHB thereof are skewed to the left, and thus receive a light beam that has passed through an exit pupil EPHB on the right side of the imaging lens TL. Therefore, the pixels SA are arranged with regularity in the horizontal direction, and an object image obtained by this group of pixels is taken as an image A. When the pixels SB are also arranged with regularity in the horizontal direction and an object image obtained by this group of pixels is taken as an image B, detecting the relative positions of the image A and the image B makes it possible to detect the amount by which the focus is off in the object image (the amount of defocus).

Meanwhile, in the case where the amount by which the focus is off in the vertical direction is to be detected, a configuration in which SA and the opening portion OPHA thereof are skewed upward and SB and the opening portion OPHB thereof are skewed downward may be employed. In this case, it goes without saying that the shapes of the openings OPHA and OPHB are rotated by 90 degrees.

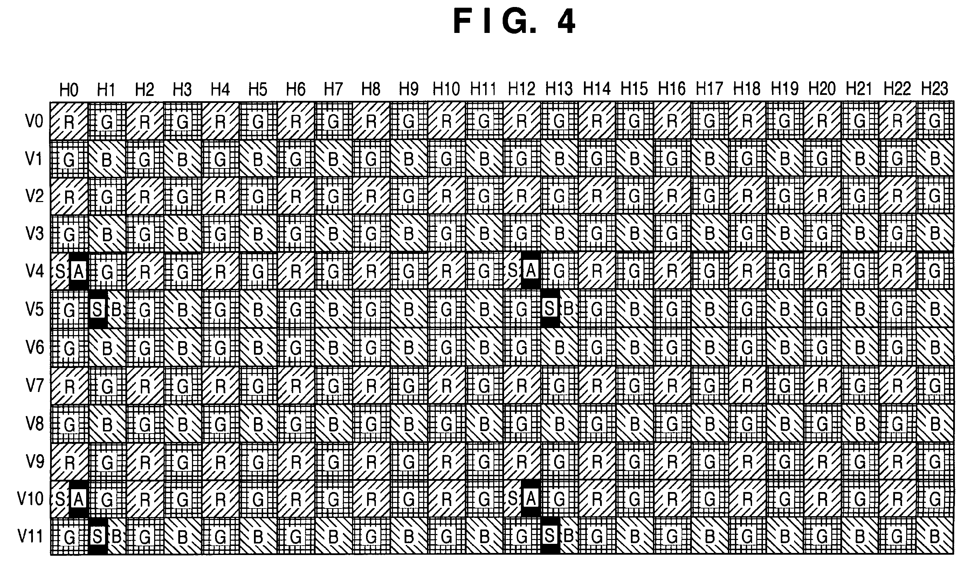

FIG. 4 is a diagram illustrating an example of the pixel arrangement in the image sensor according to the present embodiment. Recently, image sensors having a high number of pixels, from several millions of pixels to more than ten million pixels, have come into practical use, and thus for the sake of simplicity, the descriptions in the present embodiment shall discuss an arrangement of 24 pixels by 12 pixels. Furthermore, although image sensors are typically provided with light-shielding optical black pixels (abbreviated hereinafter as "OB pixels") serving as a reference for pixel output as appropriate, these OB pixels have also been omitted from FIG. 4 for the sake of simplicity.

The pixel arrangement in the present embodiment is based on a 2 x 2 Bayer array. The letters G, R, and B written in FIG. 4 indicate green, red, and blue color filters, respectively. Furthermore, the SA and SB pixels, which are the focus detection pixels, are interspersed with regularity at a predetermined ratio in some portions of the Bayer array image sensor. As shown in FIG. 4, the focus detection pixels SA, which are basis pixels for phase difference AF, are discretely arranged in a row V4 twelve pixels apart from each other in the pupil division direction, and the focus detection pixels SB, which are reference pixels for phase difference AF, are discretely arranged in a row V5 twelve pixels apart from each other in the pupil division direction. Finding the image skew amount for the pixels SA and SB in the rows V4 and V5 makes it possible to obtain the amount of defocus of the imaging lens. In addition, the configuration is such that pixels SA and SB are arranged with the same regularity in rows V10 and V11 as well.

Because focus detection pixels are taken as missing pixels and interpolated using the information of surrounding normal pixels, the pixels SA and SB are discretely arranged so that normal pixels for interpolation are arranged in the periphery of the focus detection pixels and so as to suppress image degradation through this interpolation. Accordingly, these pixels are arranged discretely in the pupil division direction, and are also arranged discretely in the direction perpendicular to the pupil division direction, which corresponds, in the present embodiment, to the row direction. The basis and reference pixel pairs in V4 and V5 and the basis and reference pixel pairs in V10 and V11 are arranged so as to be five rows apart. Note that the arrangement in the present embodiment is simply an exemplary arrangement, and the invention is not limited to this arrangement.

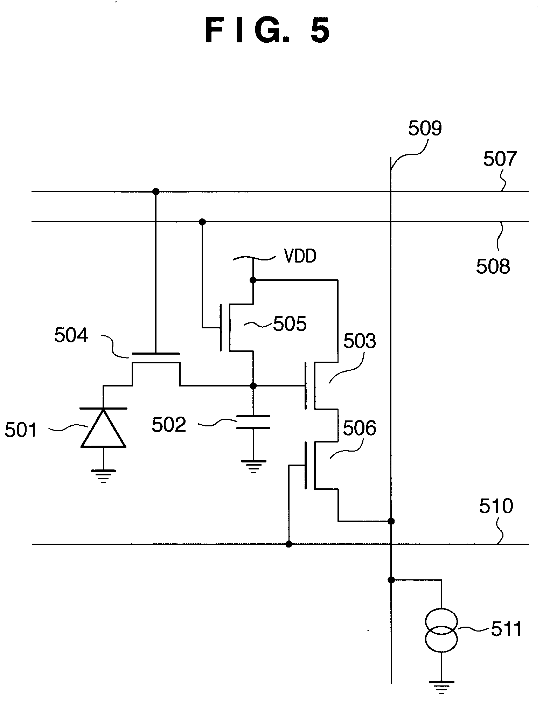

Next, operations of the CMOS sensor employed in the present embodiment shall be briefly described using FIG. 5.

FIG. 5 illustrates the circuit configuration of a single pixel in the CMOS sensor. In FIG. 5, 501 represents a photodiode (abbreviated as "PD" hereinafter), whereas 502 and 503 represent a floating diffusion amplifier for converting a signal charge accumulated in the aforementioned PD 501 into a voltage. Specifically, 502 represents a floating diffusion capacitor (abbreviated as "FD" hereinafter), whereas 503 represents an MOS transistor amplifier. 504 represents a transfer gate (abbreviated as "TX" hereinafter) for transferring the signal charge of the PD 501 to the floating diffusion capacitor, whereas 505 represents a reset gate (abbreviated as "RES" hereinafter) for resetting the PD 501 and the FD 502. 506 represents a pixel selection MOS transistor (abbreviated as "SEL" hereinafter). 507 represents a common signal line for controlling TX; 508 represents a common signal line for controlling RES; and 509 represents a vertical output line for outputting the voltage output of the FD amplifier. Finally, 510 represents a signal line for controlling SEL, and 511 represents a load current source of the FD amplifier connected to the vertical output line.

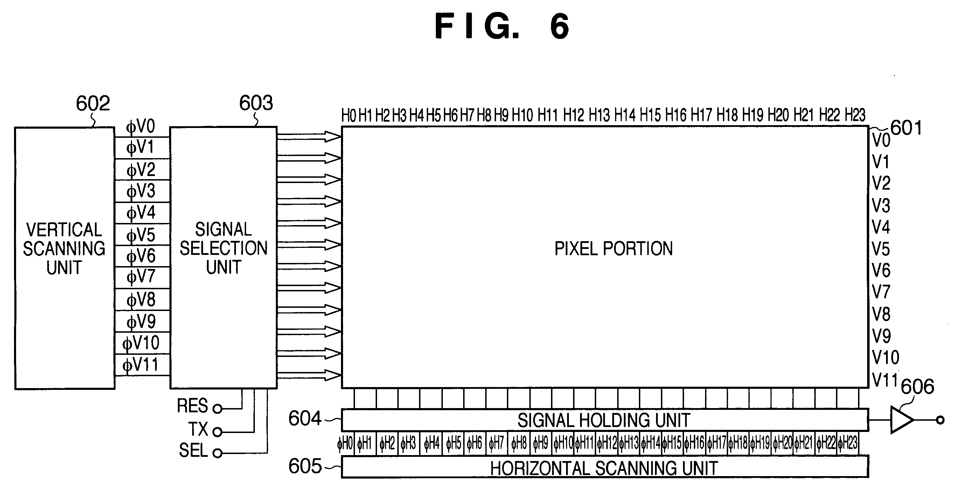

FIG. 6 is a block diagram illustrating the overall configuration of the CMOS sensor. 601 represents a pixel portion, in which the various pixels illustrated in FIG. 4 are arranged. The constituent elements in each pixel are configured as illustrated in FIG. 5. 602 represents a vertical scanning unit, which is capable of accumulation readout on a row-by-row basis by outputting sequential scanning signals such as ϕV0, ϕV1, ϕV2, and so on up to ϕV11. 603 represents a signal selection unit, into which the reset signal RES, transfer signal TX, and selection signal SEL, which are outputted at predetermined timings, are inputted by a timing generator circuit (abbreviated as "TG" hereinafter) (not shown), and which outputs those signals as appropriate to rows specified by vertical scanning signals outputted from the vertical scanning unit 602. 604 represents a signal holding unit, which, at the time of signal readout, temporarily stores the pixel output of one row selected by the SEL signal, using a sample hold signal (not shown). 605 represents a horizontal scanning unit, which causes the pixel signals temporarily stored in the signal holding unit 604 to be sequentially inputted into an output amplifier 606 and outputted from the CMOS sensor, by outputting sequential scanning signals such as ϕH0, ϕH1, ϕH2, and so on up to ϕH23.

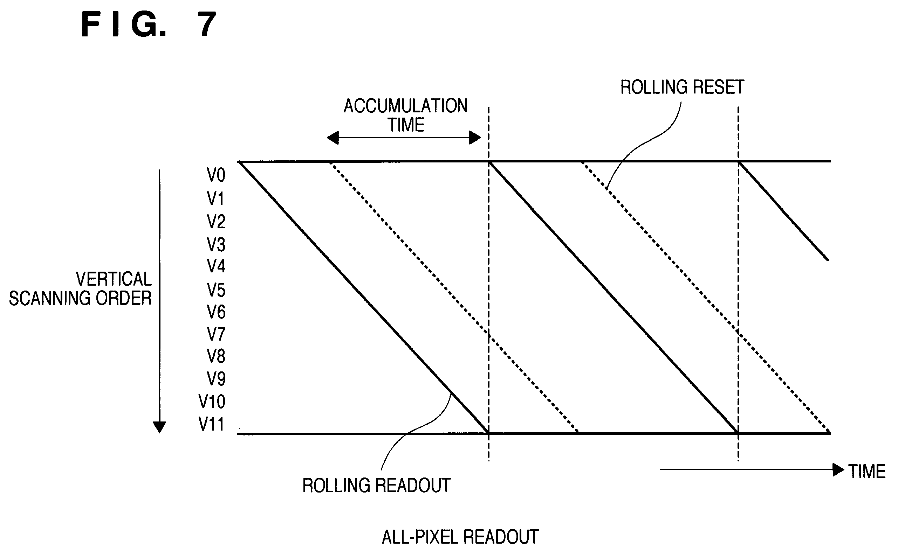

FIG. 7 is a diagram for illustrating the accumulation and readout performed by the CMOS sensor, and illustrates operations performed in an all-pixel readout mode. FIG. 7 also schematically illustrates control based on a known rolling shutter. Because this is known technology, this shall be described only briefly.

First, the horizontal axis expresses the passage of time, and here, the pixel signals for all of the 24 x 12 pixels are sequentially captured through the rolling shutter operations. The vertical direction represents the vertical scanning order, and here, the rows from V0 to V12 are sequentially scanned on a row-by-row basis. The diagonal broken lines in FIG. 7 indicate rolling reset operations executed prior to readout, whereas the diagonal solid lines indicate rolling readout. Rolling readout includes charge transfer from PD to FD, temporary storage in the signal holding unit, and external output operations performed through horizontal scanning. The accumulation time is defined by the time interval of rolling resets and rolling readouts, and can be changed by changing the timing of rolling resets. In the case where a longer accumulation than the accumulation time illustrated in FIG. 7 is desired, the rolling readout interval may be set to be longer.

In this case, the normal pixels and focus detection pixels are controlled under the same accumulation time, and the focus detection pixels, whose openings are partially blocked from light, have a lower signal level than the normal pixels. As disclosed in Patent Document 3, the necessary S/N ratio cannot be obtained, and thus it is necessary to add the output of focus detection pixels and so on in order to obtain the necessary S/N ratio. However, during a live view mode in which focus detection is necessary, when capturing/recording moving images, and so on (described later), rolling accumulation for capturing all the pixels in this manner is typically not carried out.

In recent years, it is typical for digital cameras to include specifications for live view modes, capturing/recording moving images, and so on, and in such cases, it is necessary to refresh the image display at a frame rate of 30 frames/second, thereby obtaining a smooth moving image. For this reason, readout is performed having thinned the number of pixels. Furthermore, during the live view mode, when capturing/recording moving images, and so on, focus detection operations are executed, and still images are captured based on the focus detection result detected at that time. Therefore, focus detection is not necessary with still images, in which all the pixels are read out. In addition, with rolling control, accumulation timings differ between the top and bottom of the screen, and therefore when capturing still images, a mechanical shutter is typically used, and control is typically not carried out in a rolling mode in this case.

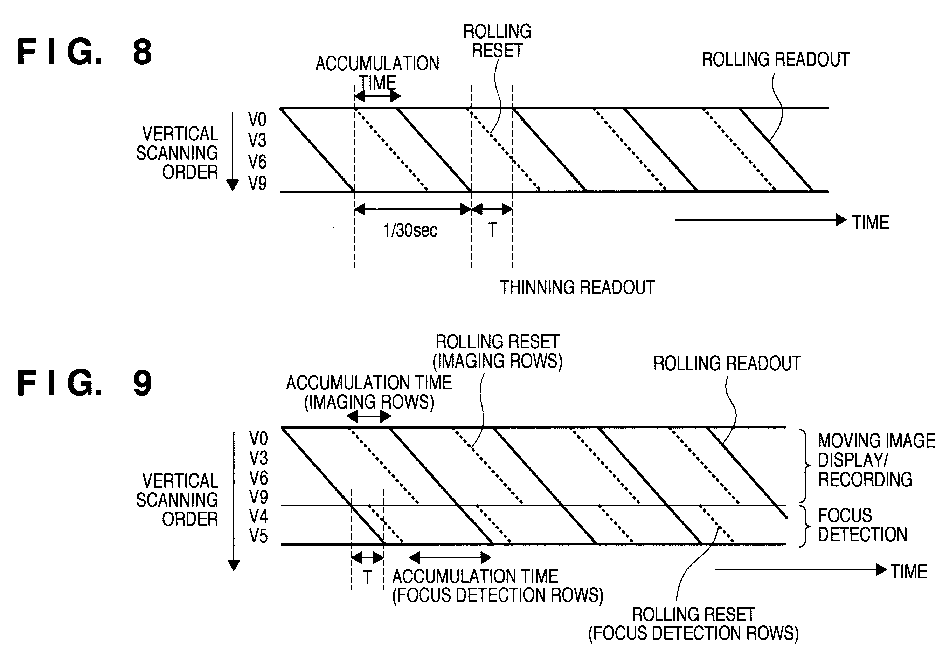

FIG. 8 is a diagram schematically illustrating accumulation and readout during thinning operations. The rolling accumulation and readout operations during thinning operations are basically the same as those shown in FIG. 7. As with FIG. 7, the horizontal axis expresses the passage of time, and the vertical axis expresses the rows that are scanned in the vertical direction. As shown in FIG. 8, the number of rows used in interlaced scanning is set so that the moving image appears smooth; for example, readout within 1/30 of a second is set so that a 30-frame moving image can be displayed. Of course, it goes without saying that the invention is not limited to 30 frames. A certain degree of smoothness can be obtained as long as there are at least approximately 20 frames.

The present embodiment describes an example in which the vertical scanning is interlaced scanning that scans every third row and 30 frames are read out. Therefore, in FIG. 8, readout is executed for four rows that have been thinned in the vertical direction, and if the time T denoted in FIG. 8 is greater than or equal to 0, a 30-frame moving image can be displayed. In addition, in the moving image display, rows in which focus detection pixels are not arranged, or V0, V3, V6, and V9, are read out, and thus image degradation does not occur.

FIG. 9 is a diagram schematically illustrating accumulation and readout during thinning operations in the case where focus detection operations are executed. The rolling accumulation and readout operations during thinning operations are basically the same as those shown in FIG. 8. As with FIG. 8, the horizontal axis expresses the passage of time, and the vertical axis expresses the rows that are scanned in the vertical direction.

As shown in FIG. 9, in the thinning operations during focus detection, the rows V0, V3, V6, and V9, which are used for live view and capturing/recording moving images as illustrated in FIG. 8, are first scanned by the vertical scanning unit. After this, rows V4 and V5, which are used for focus detection, are vertically scanned in series, thereby performing accumulation and readout control. In FIG. 9, the diagonal solid lines indicate rolling readout operations, and because the vertical output line is common among the various rows, it is necessary to scan in the vertical direction and execute sequential readouts on a row-by-row basis. The diagonal broken lines shown in FIG. 9 indicate rolling reset operations executed prior to readout, and because RES and TX control lines are present for each row used in live view/moving image recording and each row used in focus detection, parallel control is possible. Accordingly, it is possible to execute rolling resets independently for the imaging rows and the focus detection rows, as shown in FIG. 9; therefore, the imaging rows and the focus detection rows can be caused to have different reset timings and thus can be caused to have different accumulation times. For this reason, accumulation control can be executed for both simultaneously so as to achieve appropriate exposures. With a configuration such as that described in the present embodiment, the S/N ratio of the focus detection pixels can be improved without increasing the number of control signal lines and causing problems such as a decrease in the opening surface area of pixels. In addition, the present embodiment is further advantageous in terms of the S/N ratio because noise from pixel amplifiers, readout amplifiers, or the like is not added multiple times, as with frame addition.

Furthermore, in the present embodiment, two rows are assumed to be employed as the rows to be read out during the interval of a margin time T for 30 frames, and thus the rows V4 and V5 are read out. The number of rows with focus detection pixels to be additionally read out may be determined as appropriate based on the margin time T, or based on a permissible moving image frame rate, and may be determined even in the case where the margin time T is not available.

### (Second Embodiment)

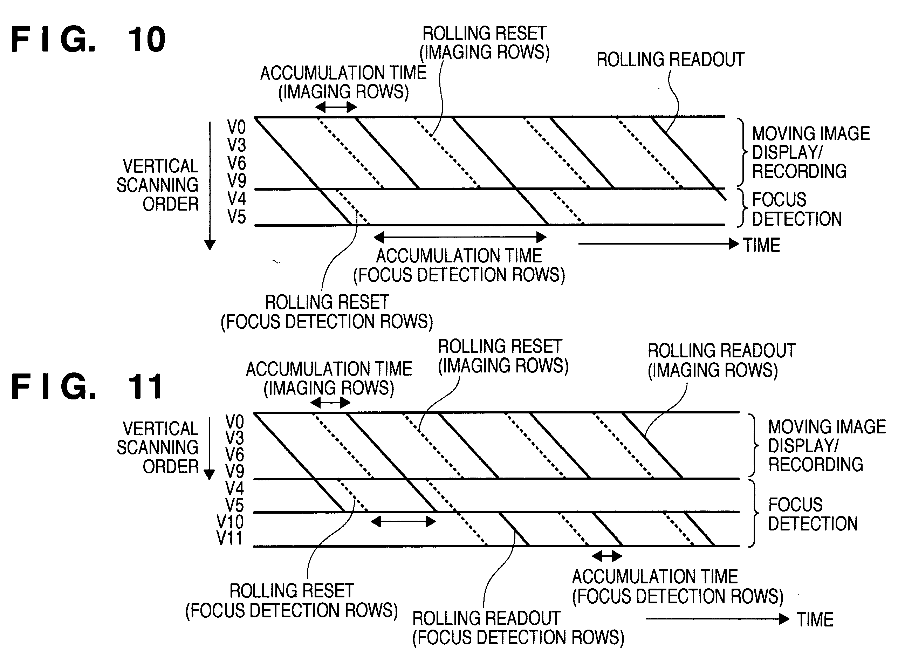

FIG. 10 is a diagram illustrating operations according to a second embodiment, and is a variation on FIG. 9. In the present embodiment, the readout cycle is caused to be different depending on the focus detection row, and the accumulation time for focus detection pixels has been extended even further than in FIG. 9. FIG. 10 illustrates an example in which a single focus detection row is read out for every two frames of a moving image. The readout cycle of focus detection pixels may be determined as appropriate while referring to the output results of the focus detection pixels.

### (Third Embodiment)

FIG. 11 is a diagram illustrating operations according to a third embodiment, and is a further variation on FIG. 9. The present embodiment describes an example in which the margin time T is insufficient during the live view, the capturing/recording of moving images, and so on, and switches, on a frame-by-frame basis, the focus detection rows to be read out. In FIG. 11, the readout from the focus detection rows V4 and V5 is switched to readout from the rows V10 and V11 from the third frame on; this makes it possible to move the focus detection rows without increasing the readout time.

While the present invention has been described with reference to exemplary embodiments, it is to be understood that the invention is not limited to the disclosed exemplary embodiments. The scope of the following claims is to be accorded the broadest interpretation.

This application claims the benefit of Japanese Patent Application No. 2009-065221, filed March 17, 2009.

## Claims

1. An image capturing apparatus comprising:
an image sensor (107) having multiple pixels arranged two-dimensionally, the image sensor including image sensing pixels adapted to generate a signal for image generation by photoelectrically converting an object image formed by an imaging lens (TL), and focus detection pixels adapted to divide the pupil region of the imaging lens into pupil regions and generate a signal for phase difference detection by photoelectrically converting object images from the pupil regions obtained by the division;
a control means adapted to control, in a thinning readout mode in which the signals of the multiple pixels are thinned and read out, the accumulation times of charges in imaging rows used for image generation and focus detection rows including the focus detection pixels independent from each other by setting the accumulation times of charges in focus detection rows longer than the accumulation times of charges in imaging rows; and
wherein, in the thinning readout mode, said control means is adapted to control to first read out signals of pixels of which the imaging rows are configured and then to read out signals of pixels of which the focus detection rows are configured in series in one frame, wherein the read out is executed sequentially on a row-by-row basis.

2. The image capturing apparatus according to claim 1, wherein, in the thinning readout mode, the readout cycle for signals of pixels of which the focus detection rows are configured is the same as or longer than the readout cycle for signals of pixels of which the imaging rows are configured.

3. The image capturing apparatus according to claim 1, wherein the image sensor (107) is a CMOS image sensor.

4. The image capturing apparatus according to claim 1, wherein the image sensor (107) has a plurality of focus detection rows, and, in the thinning readout mode, different focus detection rows are read out in a first frame in which the imaging rows and the focus detection rows are read out and in a second frame in which the imaging rows and the focus detection rows are read out.

5. The image capturing apparatus according to claim 1, wherein, in the thinning readout mode, the focus detection row to be read out is changed on a frame-by-frame basis.

6. The image capturing apparatus according to claim 1, wherein, in the thinning readout mode, said control means is adapted to set different timings for resetting pixels of the imaging rows and for resetting pixels of the focus detection rows.

7. The image capturing apparatus according to claim 1, further comprising mode selection means adapted to select one of a still image mode in which an image signal for a still image is generated from output signal of the image sensor (107) and a moving image mode in which image signals of a plurality of frames for moving image are generated from output signal of the image sensor, and wherein, in the thinning readout mode, said control means is adapted to control an accumulation operation of the imaging rows used for image generation and an accumulation operation of the focus detection rows including the focus detection pixels independently in one frame when the moving image mode is selected by said mode selection means.

8. The image capturing apparatus according to claim 7, wherein the still image mode is an all pixel read mode in which all pixels of the multiple pixels are read out and the moving image mode is a thinning read mode in which the multiple pixels are thinned and read out.

9. A method of controlling an image capturing apparatus including an image sensor (107) having multiple pixels arranged two-dimensionally, the image sensor including image sensing pixels that generate a signal for image generation by photoelectrically converting an object image formed by an imaging lens, and focus detection pixels that divide the pupil region of the imaging lens into pupil regions and that generate a signal for phase difference detection by photoelectrically converting object images from the pupil regions obtained by the division, said method comprising the steps of;
controlling, in a thinning readout mode in which the signals of the multiple pixels are thinned and read out, the accumulation times of charges in imaging rows used for image generation and focus detection rows including the focus detection pixels independent from each other by setting the accumulation times of charges in focus detection rows longer than the accumulation times of charges in imaging rows, and
controlling to first read out signals of pixels of which the imaging rows are configured and then to read out signals of pixels of which the focus detection rows are configured in series in one frame, wherein the read out is executed sequentially on a row-by-row basis.

## Patentansprüche

1. Bildaufnahmevorrichtung, mit:
einem Bildsensor (107) mit mehreren Pixeln, die zweidimensional angeordnet sind, wobei der Bildsensor Bilderfassungspixel, die dazu angepasst sind, ein Signal zur Bilderzeugung durch fotoelektrisches Umwandeln eines Objektbildes, das durch eine Abbildungslinse (TL) gebildet wird, zu erzeugen, und Fokuserfassungspixel umfasst, die dazu angepasst sind, die Pupillenregion der Abbildungslinse in Pupillenregionen aufzuteilen und ein Signal für eine Phasendifferenzerfassung durch fotoelektrisches Umwandeln von Objektbildern von den Pupillenregionen, die durch die Aufteilung erhalten werden, zu erzeugen;
einer Steuerungseinrichtung, die dazu angepasst ist, in einer Ausdünnungsauslesebetriebsart, bei der die Signale der mehreren Pixel ausgedünnt und ausgelesen werden, die Akkumulationszeiten von Ladungen in Abbildungsreihen, die für eine Bilderzeugung verwendet werden, und Fokuserfassungsreihen, die die Fokuserfassungspixel umfassen, unabhängig voneinander dadurch zu steuern, dass die Akkumulationszeiten von Ladungen in Fokuserfassungsreihen länger sind als die Akkumulationszeiten von Ladungen in Abbildungsreihen; und
wobei die Steuerungseinrichtung in der Ausdünnungsauslesebetriebsart dazu angepasst ist, derart zu steuern, um zuerst Signale von Pixeln auszulesen, aus denen die Abbildungsreihen konfiguriert sind, und dann Signale von Pixeln auszulesen, aus denen die Fokuserfassungsreihen konfiguriert sind, in Serie in einem Rahmen, wobei das Auslesen sequentiell Reihe für Reihe ausgeführt wird.

2. Bildaufnahmevorrichtung gemäß Anspruch 1, wobei in der Ausdünnungsauslesebetriebsart der Auslesezyklus für Signale von Pixeln, aus denen die Fokuserfassungsreihen konfiguriert sind, der gleiche oder länger ist als der Auslesezyklus für Signale von Pixeln, aus denen die Abbildungsreihen konfiguriert sind.

3. Bildaufnahmevorrichtung gemäß Anspruch 1, wobei der Bildsensor (107) ein CMOS-Bildsensor ist.

4. Bildaufnahmevorrichtung gemäß Anspruch 1, wobei der Bildsensor (107) eine Vielzahl von Fokuserfassungsreihen umfasst und in der Ausdünnungsauslesebetriebsart unterschiedliche Fokuserfassungsreihen in einem ersten Rahmen, in dem die Abbildungsreihen und die Fokuserfassungsreihen ausgelesen werden, und in einem zweiten Rahmen, in dem die Abbildungsreihen und die Fokuserfassungsreihen ausgelesen werden, ausgelesen werden.

5. Bildaufnahmevorrichtung gemäß Anspruch 1, wobei die auszulesende Fokuserfassungsreihe in der Ausdünnungsauslesebetriebsart Rahmen für Rahmen geändert wird.

6. Bildaufnahmevorrichtung gemäß Anspruch 1, wobei die Steuerungseinrichtung in der Ausdünnungsauslesebetriebsart dazu angepasst ist, unterschiedliche Zeitpunkte zum Zurücksetzen von Pixeln der Abbildungsreihen und zum Zurücksetzen von Pixeln der Fokuserfassungsreihen einzustellen.

7. Bildaufnahmevorrichtung gemäß Anspruch 1, weiterhin mit einer Betriebsartauswahleinrichtung, die dazu angepasst ist, eine Standbildbetriebsart, bei der ein Bildsignal für ein Standbild von einem Ausgabesignal des Bildsensors (107) erzeugt wird, oder eine Bewegtbildbetriebsart, bei der Bildsignale einer Vielzahl von Rahmen für ein Bewegtbild von einem Ausgabesignal des Bildsensors erzeugt werden, auszuwählen, und wobei die Steuerungseinrichtung in der Ausdünnungsauslesebetriebsart dazu angepasst ist, eine Akkumulationsoperation der Abbildungsreihen, die für eine Bilderzeugung verwendet werden, und eine Akkumulationsoperation der Fokuserfassungsreihen, die die Fokuserfassungspixel umfassen, unabhängig in einem Rahmen zu steuern, wenn die Bewegtbildbetriebsart durch die Betriebsartauswahleinrichtung ausgewählt wird.

8. Bildaufnahmevorrichtung gemäß Anspruch 7, wobei die Standbildbetriebsart eine Gesamtpixellesebetriebsart ist, bei der alle Pixel der mehreren Pixel ausgelesen werden, und die Bewegtbildbetriebsart eine Ausdünnungsauslesebetriebsart ist, bei der die mehreren Pixel ausgedünnt und ausgelesen werden.

9. Verfahren des Steuerns einer Bildaufnahmevorrichtung mit einem Bildsensor (107) mit mehreren Pixeln, die zweidimensional angeordnet sind, wobei der Bildsensor Bilderfassungspixel, die ein Signal zur Bilderzeugung durch fotoelektrisches Umwandeln eines Objektbildes, das durch eine Abbildungslinse gebildet wird, erzeugen, und Fokuserfassungspixel umfasst, die die Pupillenregion der Abbildungslinse in Pupillenregionen aufteilen und die ein Signal zur Phasendifferenzerfassung durch fotoelektrisches Umwandeln von Objektbildern von den Pupillenregionen, die durch die Aufteilung erhalten werden, erzeugen, wobei das Verfahren die Schritte aufweist;
Steuern, in einer Ausdünnungsauslesebetriebsart, in der die Signale der mehreren Pixel ausgedünnt und ausgelesen werden, der Akkumulationszeiten von Ladungen in Abbildungsreihen, die für eine Bilderzeugung verwendet werden, und Fokuserfassungsreihen, die die Fokuserfassungspixel umfassen, unabhängig voneinander, dadurch, dass die Akkumulationszeiten von Ladungen in Fokuserfassungsreihen länger eingestellt werden als die Akkumulationszeiten von Ladungen in Abbildungsreihen; und
Steuern, um zuerst Signale von Pixeln, aus denen die Abbildungsreihen konfiguriert sind, auszulesen und dann Signale von Pixeln, aus denen die Fokuserfassungsreihen konfiguriert sind, auszulesen, in Serie in einem Rahmen, wobei das Auslesen sequentiell Reihe für Reihe ausgeführt wird.

## Revendications

1. Appareil de capture d'image comprenant :
un capteur d'image (107) ayant de multiples pixels agencés de façon bidimensionnelle, le capteur d'image incluant des pixels de détection d'image conçus pour générer un signal pour génération d'image en convertissant de façon photoélectrique une image d'objet formée par un objectif de formation d'image (TL), et des pixels de détection de mise au point conçus pour diviser la région de pupille de l'objectif de formation d'image en régions de pupille et à générer un signal pour détection de différence de phase en convertissant de façon photoélectrique des images d'objet provenant des régions de pupille obtenues par la division ;
un moyen de commande conçu pour commander, dans un mode de lecture avec amincissement dans lequel les signaux des multiples pixels sont amincis et lus, les temps d'accumulation de charges dans des lignes de formation d'image utilisées pour génération d'image et des lignes de détection de mise au point incluant les pixels de détection de mise au point indépendamment les uns des autres en réglant les temps d'accumulation de charges dans les lignes de détection de mise au point plus longs que les temps d'accumulation de charges dans les lignes de formation d'image, et
dans lequel, en mode de lecture avec amincissement, ledit moyen de commande est conçu pour commander pour lire d'abord les signaux des pixels dont sont constituées les lignes de formation d'image et pour lire ensuite les signaux des pixels dont sont constituées les lignes de détection de mise au point en série dans une seule trame, la lecture s'exécutant séquentiellement sur une base ligne par ligne.

2. Appareil de capture d'image selon la revendication 1, dans lequel, en mode de lecture avec amincissement, le cycle de lecture pour les signaux des pixels dont sont constituées les lignes de détection de mise au point est le même que ou plus long que le cycle de lecture pour les signaux des pixels dont sont constituées les lignes de formation d'image.

3. Appareil de capture d'image selon la revendication 1, dans lequel le capteur d'image (107) est un capteur d'image à CMOS.

4. Appareil de capture d'image selon la revendication 1, dans lequel le capteur d'image (107) comporte une pluralité de lignes de détection de mise au point, et, en mode de lecture avec amincissement, des lignes différentes de détection de mise au point sont lues dans une première trame dans laquelle les lignes de formation d'image et les lignes de détection de mise au point sont lues et dans une seconde trame dans laquelle les lignes de formation d'image et les lignes de détection de mise au point sont lues.

5. Appareil de capture d'image selon la revendication 1, dans lequel, en mode de lecture avec amincissement, on change, sur une base trame par trame, la ligne de détection de mise au point à lire.

6. Appareil de capture d'image selon la revendication 1, dans lequel, en mode de lecture avec amincissement, ledit moyen de commande est conçu pour fixer des cadencements différents pour réinitialiser les pixels des lignes de formation d'image et pour réinitialiser les pixels des lignes de détection de mise au point.

7. Appareil de capture d'image selon la revendication 1, comprenant en outre un moyen de sélection de mode conçu pour sélectionner l'un d'un mode image fixe dans lequel un signal d'image pour une image fixe est généré à partir du signal sorti du capteur d'image (107), et d'un mode image en mouvement dans lequel des signaux d'image d'une pluralité de trames pour image en mouvement sont générés à partir du signal de sortie du capteur d'image, et dans lequel, en mode de lecture avec amincissement, ledit moyen de commande est conçu pour commander une opération d'accumulation des lignes de formation d'image utilisées pour génération d'image et une opération d'accumulation des lignes de détection de mise au point incluant les pixels de détection de mise au point indépendamment dans une seule trame lorsque le mode image en mouvement est sélectionné par ledit moyen de sélection de mode.

8. Appareil de capture d'image selon la revendication 7, dans lequel le mode image fixe est un mode de lecture de tous les pixels dans lequel tous les pixels des multiples pixels sont lus et le mode image en mouvement est un mode de lecture avec amincissement dans lequel les multiples pixels sont amincis et lus.

9. Procédé de commande d'un appareil de capture d'image incluant un capteur d'image (107) ayant de multiples pixels agencés de façon bidimensionnelle, le capteur d'image incluant des pixels de détection d'image qui génèrent un signal pour génération d'image en convertissant de façon photoélectrique une image d'objet formée par un objectif de formation d'image, et des pixels de détection de mise au point qui divisent la région de pupille de l'objectif de formation d'image en régions de pupille et qui génèrent un signal pour détection de différence de phase en convertissant de façon photoélectrique des images d'objet provenant des régions de pupille obtenues par la division, ledit procédé comprenant les étapes consistant :
à commander, dans un mode de lecture avec amincissement dans lequel les signaux des multiples pixels sont amincis et lus, les temps d'accumulation de charges dans des lignes de formation d'image utilisées pour génération d'image et des lignes de détection de mise au point incluant les pixels de détection de mise au point indépendamment les uns des autres en réglant les temps d'accumulation de charges dans les lignes de détection de mise au point plus longs que les temps d'accumulation de charges dans les lignes de formation d'image ; et
à commander pour lire d'abord les signaux des pixels dont sont constituées les lignes de formation d'image et pour lire ensuite les signaux des pixels dont sont constituées les lignes de détection de mise au point en série dans une seule trame, la lecture s'exécutant séquentiellement sur une base ligne par ligne.
